# EUROPÄISCHE PATENTSCHRIFT

(11) **EP 3 043 473 B1**
(45) Veröffentlichungstag und Bekanntmachung des Hinweises auf die Patenterteilung: **18.05.2022**
(21) Anmeldenummer: 15150286.1
(22) Anmeldetag: 07.01.2015
(51) Int. Cl.: H03K 17/0814, H02M 1/34, H02H 9/04, H02J 3/00

(54) **Schaltungsanordnung für Thyristorsteller**
Circuit assembly for thyristor controller
Circuit pour variateur à thyristor

(43) Veröffentlichungstag der Anmeldung: 13.07.2016
(73) Patentinhaber: ABB AG, 68309 Mannheim (DE)
(72) Erfinder: Boll, Gerd, 68623 Lampertheim (DE); Njeik, Collins-Mboh, 68199 Mannheim (DE); Schleger, Christian, 68309 Mannheim (DE); Werle, Ludwig, 69123 Heidelberg (DE)
(74) Vertreter: Wesch, Arno

(56) Entgegenhaltungen:
- CN-A- 101 917 011
- DE-A1- 1 538 154
- DE-A1- 10 221 714
- DE-C1- 19 844 823
- DE-U1- 8 716 005
- US-A1- 2001 026 427
- US-A1- 2006 220 471

## Beschreibung

Die Erfindung betrifft einen Thyristorsteller nach dem Oberbegriff des Patentanspruchs 1.

Eine Vorrichtung mit Thyristoren, welche zur Verbindung von Phasen einer Quelle mit denen einer Last verwendet wird, ist aus der US 2006/ 220 471 A1 bereits bekannt. Die DE 102 21 714 A1 zeigt vor diesem Hintergrund einen Überspannungsschutz.

Es ist allgemein bekannt, dass Thyristoren dazu dienen können, die Leistungsaufnahme einer elektrischen Last zu steuern, indem der durch den Thyristor fließende Strom nur für einen jeweiligen Teil eines zur Verfügung stehenden Zeitintervalls aufrecht erhalten wird. Im Rahmen dieser Anmeldung sind insbesondere Lasten in Niederspannungsnetzen von beispielsweise dreiphasig 380V von Interesse, wobei selbstverständlich auch Spannungen im Bereich von 400V, 500V und auch 1200V von Relevanz sind. Ein Thyristor wird dann leitend, wenn nach dem Zünden genügend freie Ladungsträger zur Verfügung stehen, die einen Stromfluss gewährleisten. Er erlischt wieder, wenn die freien Ladungsträger zur Neige gehen bzw. nicht mehr vorhanden sind.

Wird eine induktive Last geschaltet, versucht diese Last den Strom aufrecht zu erhalten. Das führt dazu, dass sich nach erfolgter Abschaltung eine Spannung zwischen

Anode und Kathode des Thyristors aufbaut, die diesen zerstören kann. Aus diesem Grund wird meist eine so genannte TSE (Träger Stau Effekt) - Beschaltung parallel zum Thyristor geschaltet. Üblicherweise besteht diese aus einem in Reihe geschalteten Widerstand R und einer Kapazität C. Diese RC-Beschaltung wird im Folgenden Einzelbeschaltung genannt.

Die Auslegekriterien für die Einzelbeschaltung sind unter Anderem:
- die maximale Sperrspannung des Thyristors,
- die zulässige Spannungssteilheit am Thyristor,
- der zulässige Strom beim Einschalten des Thyristors,
- Verluste in der Beschaltung sowie im Thyristor.

Hinweise für die Auslegung von DC-Mittelpunktschaltungen und -brücken erhält man üblicherweise aus diverser Literatur sowie von den Thyristorproduzenten. Wichtig ist in diesem Zusammenhang, dass die Beschaltungsverluste weitestgehend von der Größe der Beschaltungskapazität abhängen.

Beim Einschalten des Thyristors entsteht in der Beschaltung durch die Kapazität ein Energieverlust in Höhe von ½ * C * U² und beim Ausschalten ein meist noch höherer Wert, weil die Spannung am Thyristor überschwingt.

Zur Verlustreduktion ist die Beschaltungskapazität möglichst klein zu machen, im Idealfall so klein, dass die Einzelbeschaltung nur noch für die Begrenzung der Spannungssteilheit zuständig ist. Dies führt allerdings zu einem großen Überschwingen der Spannung am Thyristor. Eine Abhilfemaßnahme bietet bei diversen Schaltungsvarianten (zum Beispiel Mittelpunkt- oder Brückenschaltungen) eine sogenannte Summenbeschaltung, umfassend beispielsweise 6 Dioden in B6-Konfiguration, einen Auf- und Entladewiderstand sowie eine Kapazität.

Bei einer Summenbeschaltung wird die Kapazität bei einer B6-Brücke beim Einschalten auf den Spitzenwert der verketteten Spannung aufgeladen. Ist der Schwingkreis bestehend aus Netzinduktivität und Summenbeschaltungskapazität zu schwach gedämpft, wird die Kapazität sogar überladen.

Der Entladewiderstand sorgt dafür, dass die Beschaltungskapazität dauernd entladen wird, so dass sie im Betrieb die in der Induktivität gespeicherte Energie zyklisch aufnehmen kann. Die Beschaltungskapazität der Summenbeschaltung "klemmt" die Spannung auf einen Wert, bei dem sich das Gleichgewicht einstellt, weil diese größer ist als die Kapazitäten der Einzelbeschaltung. Die sich hierbei ergebenden Verluste sind im Vergleich zu einer entsprechenden Einzelbeschaltung deutlich reduziert.

Für Thyristorsteller gibt es nur eine deutlich kleinere Auswahl an Beschaltungen als für DC-Regler. Das hängt unter anderem damit zusammen, dass es keine polarisierten Beschaltungen gibt. Die typische Beschaltung ist ein RC-Glied, in mancher Literatur finden sich zusätzlich MOVs (Metal Oxide Varistor) als Beschaltungvariante parallel zum Thyristor.

MOVs als Beschaltung sind jedoch nur sehr bedingt geeignet. Dies hat unter anderem den Hintergrund, dass idealerweise eine rechtwinkelige Kennlinie gewünscht ist, bei welcher sofort nach Eintreten der Spannungsüberhöhung ein entsprechender Stromfluss eintritt, durch den die Spannungserhöhung begrenzt wird. Dies ist bei Varistoren nicht der Fall, weil die U/I-Kennlinie keinen ausgeprägten Knick aufweist, sondern eher träge ist. Ein anderer Nachteil von Varistoren ist das schnelle Altern bei permanenter Beanspruchung.

Nachteilig an dem Stand der Technik ist, dass sich bei einem Thyristorsteller zwar die gleiche Summenbeschaltung einbauen lässt wie bei einer B6-Thyristorbrücke, diese aber nur sehr bedingt wirkt. Grund dafür ist, dass die Summenbeschaltung bei einer B6 Thyristorbrücke "zwischen den Phasen" wirkt, also quasi parallel zu einer Reihenschaltung von jeweils zwei Thyristoren wirkt und so die Spannungsspitzen am Thyristor kappt. Beim Thyristorsteller muss die Beschaltung aber nicht nur zwischen den Phasen, sondern auch zwischen Eingang und Ausgang des Thyristorstellers wirken.

Ausgehend von diesem Stand der Technik ist es Aufgabe der Erfindung, eine verbesserte Schaltungsanordnung für Thyristorsteller anzugeben, durch welche Überspannungen in zuverlässiger Weise begrenzt werden. Aufgabe der Erfindung ist es auch, einen entsprechenden Thyristorsteller anzugeben.

Eine Schaltungsanordnung ist gekennzeichnet durch
- eine zweite Diodenbrücke mit drei jeweils zwei Dioden umfassenden Brückengliedern, drei Eingängen in der elektrischen Mitte der Brückenglieder sowie einem ersten und einem zweiten Ausgang, an dem die Enden der Brückenglieder miteinander verschaltet sind,
- wobei die ersten und zweiten Ausgänge der Diodenbrücken jeweils mit identischer Polarität elektrisch miteinander verbunden sind,
- wobei die Schaltungsanordnung dafür vorgesehen ist, dass die drei Eingänge der ersten Brücke mit den Eingängen eines dreiphasigen Thyristorstellers verbunden werden und dass die drei Eingänge der zweiten Brücke mit dessen Ausgängen verbunden werden.

Die Grundidee der Erfindung besteht darin, ausgehend von der bekannten Summenbeschaltung eine weitere Diodenbrücke zu installieren, deren drei Eingänge beziehungsweise wechselspannungsseitige Anschlüsse mit den drei Ausgängen des Thyristorstellers verbunden sind. Die gleichspannungsseitigen Ausgänge der Diodenbrücken sind hierbei ebenfalls miteinander verbunden.

Beim Einschalten des Stellers an das Netz verhält sich die Schaltungsanordnung wie die Summenbeschaltung einer Mittelpunkt- oder einer Brückenschaltung. Die Kapazität wird auf den Spitzenwert der verketteten Spannung aufgeladen.

Die Thyristoren selbst liegen aber nicht wie bei der Brückenschaltung zwischen den Phasen, sondern sie liegen in den Außenleitern. Sie sind durch die jeweilige Last im Netz von den andern Thyristoren getrennt. Eine Kommutierung, bei der nur die Netzinduktivität strombegrenzend wirkt, gibt es beim Thyristorsteller nicht. Vielmehr sind Netzinduktivität, Thyristorsteller und Last in Reihe geschaltet.

An den Thyristoren selbst liegt nicht die verkettete Spannung sondern die Strangspannung an. Diese ist um √3 kleiner als die verkettete Spannung. Erst wenn eine Spannung höher wird als die Spannung an der Kapazität beginnt ein Strom über die entsprechenden Dioden und die Kapazität zu fließen und schneidet damit die Spannungsspitzen ab.

Für die Auslegung des Entladewiderstandes gelten die oben genannten Randbedingungen. Die Schaltungsanordnung schneidet erst dann die Spannungsspitzen ab, wenn die verkettete Spannung überschritten wird.

Es ergeben sich insbesondere folgende Vorteile der Schaltungsanordnung:
- Die Schaltungsanordnung ist ausschließlich aus passiven Komponenten aufgebaut und damit sehr robust.
- Spannungsspitzen werden sehr exakt abgeschnitten, abhängig nur von der Netzspannung und dem Lade- und Entladewiderstand. In weiten Bereichen ist das Verhalten fast ausschließlich von der Netzspannung abhängig. Wird die Netzspannung kleiner, greift auch die obige Beschaltung entsprechend früher ein,
- Auch bei Blocktaktung, wenn die Thyristoren längere Zeit Strom führen, wird die Kapazität nicht entladen. Die elektrischen Komponenten werden dadurch nicht mit extremen Stoßströmen beansprucht.
- Toleranzen, wie z.B. bei Varistoren, spielen keine Rolle, die Schaltung stellt sich automatisch auf die Netzspannung ein.
- Die Schaltungsanordnung wirkt sowohl bei internen als auch bei extern erzeugten Überspannungen.

Die Aufgabe wird gelöst durch einen Thyristorsteller gemäß Patentanspruch 1 mit drei Eingängen und drei Ausgängen und einer Schaltungsanordnung, wobei die die drei Eingänge der ersten Brücke der Schaltungsanordnung mit den Eingängen des dreiphasigen Thyristorstellers verbunden sind und die drei Eingänge der zweiten Brücke mit dessen Ausgängen. Die sich ergebenden Vorteile wurden bereits im Rahmen der Schaltungsauslegung erläutert.

Gemäß einer bevorzugten Variante der erfindungsgemäßen Schaltungsanordnung umfasst wenigstens eine der Diodenbrücken ein viertes Brückenglied, welches dafür vorgesehen ist, in seiner elektrischen Mitte mit einem Neutralleiter N verbunden zu werden. Somit ist in vorteilhafter Weise auch ein einphasiger Betrieb ermöglicht.

Zwischen dem Eingang und dem Ausgang einer jeweiligen Phase des Thyristorstellers sind zwei gegenläufig verschaltete Thyristoren mit einer Einzelbeschaltung aus einem in Reihe geschaltetem Widerstand und einer Kapazität vorhanden. Dies ist eine geeignete Grundschaltung zum biploaren Durchschalten beziehungsweise Sperren einer Phase. Vorzugsweise sind die Kapazitäten der Einzelbeschaltung der Thyristoren kleiner als die Kapazität der Schaltungsanordnung.

Eine Schaltungsanordnung für Thyristorsteller könnte umfassen
- eine erste Diodenbrücke mit zwei jeweils zwei Dioden umfassenden Brückengliedern, zwei Eingängen in der elektrischen Mitte der Brückenglieder sowie einem ersten und einem zweiten Ausgang, an dem die Enden der Brückenglieder miteinander verschaltet sind,
- wobei zwischen den beiden Ausgängen eine Reihenschaltung eines ersten und eines zweiten elektrischen Widerstandes vorgesehen ist,
- wobei parallel zu dem zweiten Widerstand eine elektrische Kapazität geschaltet ist, wobei
- eine zweite Diodenbrücke mit einem jeweils zwei Dioden umfassenden Brückenglied, einem Eingang in der elektrischen Mitte des Brückengliedes, sowie einem ersten und einem zweiten Ausgang, mit denen die jeweiligen Enden des Brückengliedes verschaltet sind,
- wobei die ersten und zweiten Ausgänge der Diodenbrücken jeweils mit identischer Polarität elektrisch miteinander verbunden sind,
- wobei die Schaltungsanordnung dafür vorgesehen ist, dass der erste Eingang der ersten Brücke mit dem Eingang eines einphasigen Thyristorstellers verbunden wird, dass der Eingang der zweiten Brücke mit dessen Ausgang verbunden wird und dass der zweite Eingang der ersten Brücke dafür vorgesehen ist, mit einem Neutralleiter N verbunden zu werden.

Diese Ausführungsform entspricht der einphasigen Form der zuvor offenbarten dreiphasigen Variante, wobei hier eine Verbindung zu einem Neutralleiter obligatorisch für den Betrieb ist. Die sich ergebenden Vorteile entsprechen im Wesentlichen den zuvor erörterten Vorteilen der dreiphasigen Variante. Selbstverständlich sind auch dreiphasige Varianten mit beispielsweise zwei B12 Diodenbrücken denkbar.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine exemplarische erste Diodenbrücke mit Widerstand und Kapazität,
- Fig. 2: eine exemplarische Schaltungsanordnung,
- Fig. 3: einen exemplarischen Thyristorsteller mit Schaltungsanordnung sowie
- Fig. 4: einen exemplarischen dreiphasigen Thyristorsteller mit Schaltungsanordnung.

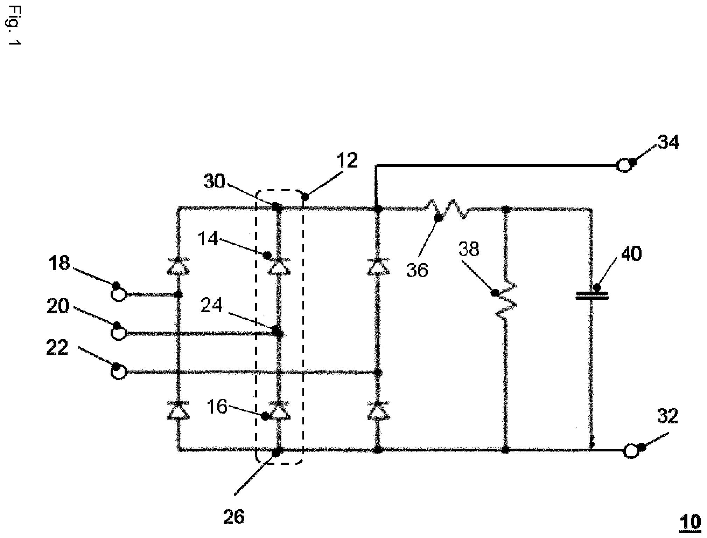

Figur 1 zeigt eine exemplarische erste Diodenbrücke mit Widerständen und Kapazität in einer Skizze 10, wobei dies dem Stand der Technik einer Summenbeschaltung entspricht. Die Diodenbrücke weist drei parallele Brückenglieder 12 auf, welche mit ihren ersten Enden 26 elektrisch auf einen ersten gemeinsamen Ausgang 32 geführt sind und mit ihren zweiten Enden 30 auf einen zweiten gemeinsamen Ausgang 34.

Ein Brückenglied 12 weist zwei in Reihe geschaltete Dioden 14, 16 auf, mit deren elektrischer Mitte 24 ein jeweiliger Eingang 18, 20, 22 der Diodenbrücke verbunden ist, so dass sich insgesamt drei Eingänge ergeben, wie sie bei einem dreiphasigen Wechselspannungsnetz benötigt werden.

Zwischen den beiden gleichspannungsseitigen Ausgängen 32, 34 sind ein (Lade-) Widerstand 36 sowie ein (Entlade-) Widerstand 38 in Reihe geschaltet. Parallel zum (Entlade-) Widerstand 38 ist eine Kapazität 40 geschaltet. Eine typische Wertekombination für die genannten Komponenten ist beispielsweise 1Ω für den Ladewiderstand 50 kΩ für den Entladewiderstand 38 und 6,8µF für die Kapazität 40 bei einer Nennspannung von beispielsweise 380V.

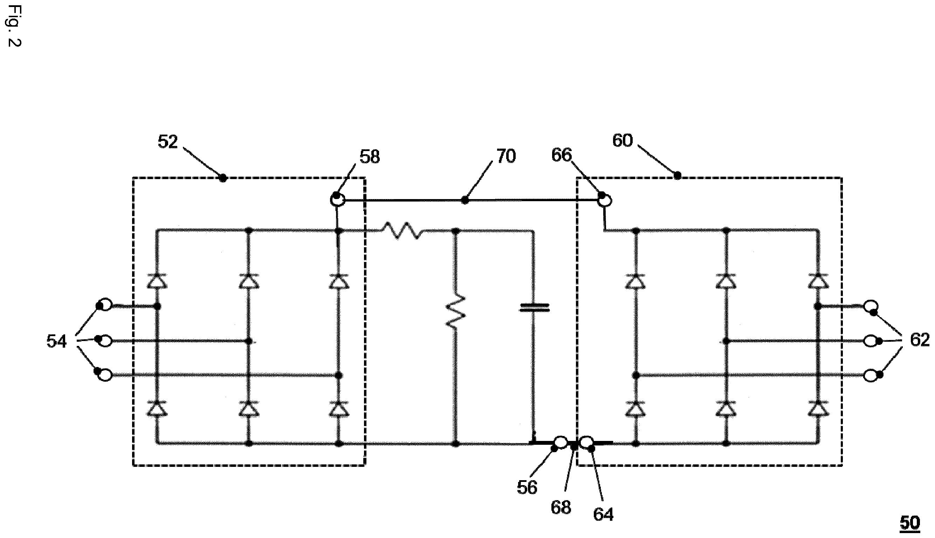

Figur 2 zeigt eine exemplarische Schaltungsanordnung 50. Ausgehend von der in der Figur 1 gezeigten Summenbeschaltung mit Diodenbrücke, Auf- und Entladewiderstand sowie Kapazität sind eine erste 52 und eine zweite 60 Diodenbrücke mit jeweils drei Brückengliedern vorgesehen. Die jeweiligen ersten gleichspannungsseitigen Ausgänge 56 und 64 sind mit einer Verbindung 68 elektrisch miteinander gekoppelt und die zweiten gleichspannungsseitigen Ausgänge 58, 66 mit einer Verbindung 70. Die drei Eingänge 54 der ersten Brücke 52 sind dafür vorgesehen, mit den Eingängen eines dreiphasigen Thyristorstellers verbunden werden und die drei Eingänge der zweiten Brücke 60 mit den Ausgängen eines dreiphasigen Thyristorstellers.

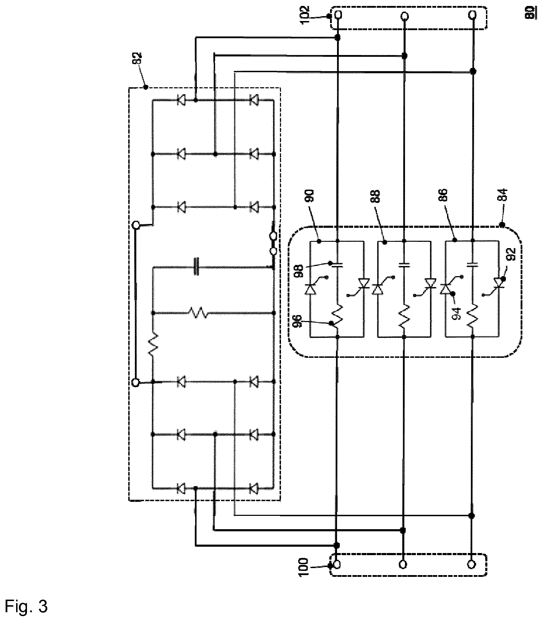

Figur 3 zeigt einen exemplarischen erfindungsgemäßen dreiphasigen Thyristorsteller 84 mit spannungsbegrenzender Schaltungsanordnung 82 in einem Prinzipschaltbild 80. Der dreiphasige Thyristorsteller 84 umfasst für jede seiner drei Phasen eine Gruppe 86, 88, 90 zweier gegenläufig geschaltete Thyristoren 92, 94, zu denen parallel eine Einzelbeschaltung aus Widerstand 96 und Kondensator 98 vorgesehen ist.

Die jeweils drei ein- und ausgangsseitigen Phasen von Thyristorsteller 84 und Schaltungsanordnung 82 sind an Eingängen 100 beziehungsweise Ausgängen 102 jeweils elektrisch zusammengefasst.

Nicht gezeigt ist ein eingangsseitiges Versorgungsnetz von beispielsweise 380V Nennspannung, durch welches der Thyristorsteller 84 über seine Eingänge 100 elektrisch versorgt wird. Das Versorgungsnetz kann vereinfacht als ideale Spannungsquelle mit einer nachgeschalteten Netzimpedanz angenommen werden. Ebenfalls nicht gezeigt ist eine ausgangsseitige Last, welche an den Ausgang 102 des Thyristorstellers 84 angeschlossen ist. Eine Last kann im weiteren Sinne als eine Impedanz angenommen werden. Sowohl Netzimpedanz als auch Lastimpedanz haben einen Einfluss auf eventuell entstehende Überspannungen, welche durch die Schaltungsanordnung 82 begrenzt werden.

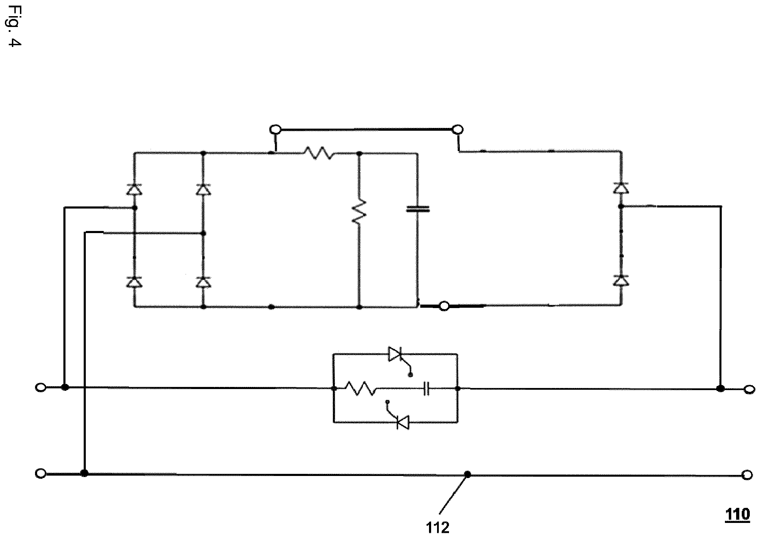

Figur 4 zeigt in einer Darstellung 110 einen exemplarischen einphasigen Thyristorsteller mit Schaltungsanordnung und einem Neutralleiter 112, welcher vom Grundprinzip dem dreiphasigen Thyristorsteller mit Schaltungsanordnung aus Figur 3 entspricht.

### Bezugszeichenliste:

- 10: exemplarische erste Diodenbrücke mit Widerstand und Kapazität
- 12: Brückenglied
- 14: erste Diode von Brückenglied
- 16: zweite Diode von Brückenglied
- 18: erster Eingang von erster Diodenbrücke
- 20: zweiter Eingang von erster Diodenbrücke
- 22: dritter Eingang von erster Diodenbrücke
- 24: elektrische Mitte von Brückenglied
- 26: erstes Ende von Brückenglied
- 30: zweites Ende von Brückenglied
- 32: erster Ausgang von erster Diodenbrücke
- 34: zweiter Ausgang von erster Diodenbrücke
- 36: erster Widerstand
- 38: zweiter Widerstand
- 40: Kapazität
- 50: exemplarische Schaltungsanordnung
- 52: erste Diodenbrücke
- 54: Eingänge von erster Diodenbrücke
- 56: erster Ausgang von erster Diodenbrücke
- 58: zweiter Ausgang von erster Diodenbrücke
- 60: zweite Diodenbrücke
- 62: Eingänge von zweiter Diodenbrücke
- 64: erster Ausgang von zweiter Diodenbrücke
- 66: zweiter Ausgang von zweiter Diodenbrücke
- 68: Verbindung von ersten Ausgängen
- 70: Verbindung von zweiten Ausgängen
- 80: exemplarischer Thyristorsteller mit Schaltungsanordnung
- 82: exemplarische Schaltungsanordnung
- 84: dreiphasiger Thyristorsteller
- 86: Thyristorsteller für erste Phase
- 88: Thyristorsteller für zweite Phase
- 90: Thyristorsteller für dritte Phase
- 92: erster Thyristor
- 94: zweiter Thyristor
- 96: Widerstand
- 98: Kapazität
- 100: Eingänge von dreiphasigem Thyristorsteller
- 102: Ausgänge von dreiphasigem Thyristorsteller
- 110: exemplarischer einphasiger Thyristorsteller mit Schaltungsanordnung
- 112: Neutralleiter

## Patentansprüche

1. Thyristorsteller (84) mit drei Eingängen (100) und drei Ausgängen (102), wobei eine Schaltungsanordnung (50, 82) vorgesehen ist, welche eine erste Diodenbrücke (52) mit drei jeweils zwei Dioden (14, 16) umfassenden Brückengliedern (12), drei Eingängen (18, 20, 22, 54) in der elektrischen Mitte (24) der Brückenglieder (12) sowie einem ersten (32, 56) und einem zweiten (34, 58) Ausgang, an dem die Enden (26, 30) der Brückenglieder (12) miteinander verschaltet sind, umfasst,
wobei die Schaltungsanordnung eine zweite Diodenbrücke (60) mit drei jeweils zwei Dioden (14, 16) umfassenden Brückengliedern (12), drei Eingängen (62) in der elektrischen Mitte (24) der Brückenglieder (12) sowie einem ersten (64) und einem zweiten (66) Ausgang, an dem die Enden (26, 30) der Brückenglieder (12) miteinander verschaltet sind, umfasst,
und wobei die ersten (32, 56, 64) und zweiten (34, 58, 66) Ausgänge der Diodenbrücken (52, 60) jeweils elektrisch miteinander verbunden (68, 70) sind,
wobei zwischen den beiden Ausgängen (32, 56 ↔ 34, 58) eine Reihenschaltung eines ersten (36) und eines zweiten (38) elektrischen Widerstandes vorgesehen ist, wobei parallel zu dem zweiten Widerstand (38) eine elektrische Kapazität (40) geschaltet ist,
wobei die drei Eingänge (18, 20, 22, 54) der ersten Brücke (52) jeweils mit den drei Eingängen (100) des dreiphasigen Thyristorstellers (84) verbunden sind, wobei die drei Eingänge (62) der zweiten Brücke (60) jeweils mit dessen drei Ausgängen (102) verbunden sind und
wobei zwischen dem Eingang und dem Ausgang einer Phase des Thyristorstellers (84) zwei gegenläufig verschaltete Thyristoren (92 ↔ 94) mit Einzelbeschaltung aus einem in Reihe geschaltetem Widerstand (96) und einer Kapazität (98) vorhanden sind.

2. Thyristorsteller nach Anspruch 1, **dadurch gekennzeichnet, dass** wenigstens eine der Diodenbrücken (52, 60) ein viertes Brückenglied (12) umfasst, welches dafür vorgesehen ist, in seiner elektrischen Mitte (24) mit einem Neutralleiter N verbunden zu werden.

## Claims

1. Thyristor controller (84) having three inputs (100) and three outputs (102), wherein a circuit assembly (50, 82) is provided which comprises a first diode bridge (52) having three bridge elements (12), each of which comprises two diodes (14, 16), having three inputs (18, 20, 22, 54) in the electrical centre (24) of the bridge elements (12) and having a first (32, 56) and a second (34, 58) output, at which the ends (26, 30) of the bridge elements (12) are connected to one another,
wherein the circuit assembly comprises a second diode bridge (60) having three bridge elements (12), each of which comprises two diodes (14, 16), having three inputs (62) in the electrical centre (24) of the bridge elements (12) and having a first (64) and a second (66) output, at which the ends (26, 30) of the bridge elements (12) are connected to one another,
and wherein the first (32, 56, 64) and second (34, 58, 66) outputs of the diode bridges (52, 60) are each electrically connected to one another (68, 70),
wherein a series connection comprising a first (36) and a second (38) electrical resistor is provided between the two outputs (32, 56 ↔ 34, 58),
wherein an electrical capacitor (40) is connected in parallel with the second resistor (38),
wherein the three inputs (18, 20, 22, 54) of the first bridge (52) are each connected to the three inputs (100) of the three-phase thyristor controller (84),
wherein the three inputs (62) of the second bridge (60) are each connected to the three outputs (102) of said three-phase thyristor controller and
wherein two thyristors (92 ↔ 94), connected in opposite directions, with individual interconnection comprising a series-connected resistor (96) and a capacitor (98) are present between the input and the output of one phase of the thyristor controller (84).

2. Thyristor controller according to Claim 1, **characterized in that** at least one of the diode bridges (52, 60) comprises a fourth bridge element (12) which is intended to have its electrical centre (24) connected to a neutral conductor N.

## Revendications

1. Commande à thyristors (84) comprenant trois entrées (100) et trois sorties (102), un ensemble formant circuit (50, 82) étant prévu qui comprend un premier pont de diodes (52), qui comporte trois éléments de pont (12) pourvus chacun de deux diodes (14, 16), trois entrées (18, 20, 22, 54) situées au point milieu électrique (24) des éléments de pont (12) ainsi qu'une première (32, 56) et une deuxième (34, 58) sortie au niveau desquelles les extrémités (26, 30) des éléments de pont (12) sont interconnectées, l'ensemble formant circuit comprenant un deuxième pont de diodes (60) qui comporte trois éléments de pont (12) pourvus chacun de deux diodes (14, 16), trois entrées (62) situées au point milieu électrique (24) des éléments de pont (12) ainsi qu'une première (64) et une deuxième (66) sortie au niveau desquelles les extrémités (26, 30) des éléments de pont (12) sont interconnectées,
et les première (32, 56, 64) et deuxième (34, 58, 66) sorties des ponts de diodes (52, 60) étant respectivement reliées électriquement (68, 70) l'une à l'autre,
un circuit série d'une première (36) et d'une deuxième (38) résistance électrique étant prévu entre les deux sorties (32, 56 <=> 34, 58),
une capacité électrique (40) étant montée en parallèle avec la deuxième résistance (38),
les trois entrées (18, 20, 22, 54) du premier pont (52) étant respectivement reliées aux trois entrées (100) de la commande à thyristors triphasée (84),
les trois entrées (62) du deuxième pont (60) étant respectivement reliées aux trois sorties (102) de celuici, et
deux thyristors (92 <=> 94) montés en opposition, qui comprennent un circuit individuel composé d'une résistance (96) montée en série et d'un condensateur (98), étant prévus entre l'entrée et la sortie d'une phase de la commande à thyristors (84).

2. Commande à thyristors selon la revendication 1, **caractérisée en ce que** l'un au moins des ponts de diodes (52, 60) comprend un quatrième élément de pont (12) qui est prévu pour être relié à un conducteur neutre N en son point milieu électrique (24).
